# EUROPÄISCHE PATENTSCHRIFT

(11) **EP 0 379 961 B1**
(45) Veröffentlichungstag und Bekanntmachung des Hinweises auf die Patenterteilung: **04.06.1997**
(21) Anmeldenummer: 90100949.8
(22) Anmeldetag: 17.01.1990
(51) Int. Cl.: H01L 31/042, H01L 31/048

(54) **Vorrichtung mit einer flexiblen Fläche zur Aufnahme fotovoltaischer Zellen**
Device with a flexible surface to receive photovoltaic cells
Dispositif de surface flexible pour supporter des cellules photovoltaiques

(30) Priorität: 17.01.1989 DE 3901186
(43) Veröffentlichungstag der Anmeldung: 01.08.1990
(73) Patentinhaber: Webasto Systemkomponenten GmbH, 82131 Stockdorf (DE)
(72) Erfinder: Raupach, Peter, D-80801 München (DE)
(74) Vertreter: Wiese, Gerhard

(56) Entgegenhaltungen:
- DE-A- 3 427 574
- FR-A- 2 466 865
- US-A- 2 962 539
- US-A- 3 411 050
- PATENT ABSTRACTS OF JAPAN Band 9, Nr. 258 (E-350)(1981), 16. Oktober 1985 & JP-A-60 107 871

## Beschreibung

Die Erfindung betrifft eine Vorrichtung mit einer flexiblen Fläche zur Aufnahme fotovoltaischer Zellen nach dem Oberbegriff des Patentanspruchs 1.

Die JP-A-60 107 871 beschreibt eine Vielzahl von Räumen, die auf Filmkörpern mittels transparenter Filme gebildet werden, während Solarmodule in diese Räume so eingebracht sind, daß sie mit den Filmkörpern und dem transparenten Film unter den Bedingungen von Ausdehnung oder Verlängerung der Module nicht dynamisch gekuppelt sind.

Die DE-A-34 27 574 zeigt ein Dach, dessen Außenseite mit fotovoltaischen Elementen besetzt ist. Der Aufbau einer solchen fotovoltaischen Zelle kann beispielsweise der DE-A 30 13 991 entnommen werden. Hierbei gelangt der sogenannte Sperrschicht Fotoeffekt bzw. Foto-Volta-Effekt zum Einsatz. Dieser entsteht als Übergang innerhalb einer Sperrschicht zwischen Halbleiter/Halbleiter, Halbleiter/Elektrolyt, Halbleiter/Metall, Metall/Elektrolyt oder in der unmittelbaren Umgebung einer Sperrschicht. Durch Lichteinfall erzeugte Ladungsträgerpaare werden im elektrischen Feld der Sperrschicht getrennt, wodurch eine ausnutzbare Spannung entsteht.

In der Praxis hat sich nun gezeigt, daß flexible Träger für derartige fotovoltaische Zellen zwar wünschenwert sind, daß deren Einsatz jedoch insbesondere im Hinblick auf die einwirkenden mechanischen Kräfte Probleme mit sich bringt.

Angesichts dieser Gegebenheiten hat sich der Erfinder das Ziel gesetzt, eine Vorrichtung der eingangs erwähnten Art dahingehend zu verbessern, daß die fotovoltaischen Elemente von den mechanischen Kräften nicht beansprucht werden. Darüber hinaus soll der Einsatz derartiger fotovoltaischer Vorrichtungen verbessert werden.

Zur Lösung dieser Aufgabe führt die Lehre nach den unabhängigen Patentansprüchen 1 und 2, die Unteransprüche geben günstige Weiterbildungen an.

Erfindungsgemäß ist die flexible Fläche eine hochreißfeste Membrane, und die auf sie aufgelegten Zellen sind dadurch schwimmend eingebettet, daß die transluzente Schutzfolie nur in den Zwischenräumen zwischen den einzelnen Zellen mit der flexiblen Fläche durch Klebung oder Schweißung verbunden ist. Auch liegt es im Rahmen der Erfindung, daß die Zellen in die flexible Fläche -- die hochreißfeste Membrane -- dadurch schwimmend eingebettet sind, daß sie in Aussparungen der flexiblen Fläche eingelegt sind und eine Verklebung nur am Folienrand der transluzenten Schutzfolie besteht; die elektrische Verbindung ist vorzugsweise im Nachhinein herstellbar.

Daß die fotovoltaischen Zellen schwimmend an der flexiblen Fläche angeordnet sind, soll aussagen, daß sie mit dieser nicht fest verbunden sind. Dabei können fotovoltaische Zellen mit einer Schicht aus amorphem Silizium oder Kadmiumderivaten auf einer Trägerplatte Verwendung finden; letztere wird auf die flexible Fläche lose aufgelegt und -- zusammen mit den elektrischen Verbindungen -- von einer transluzenten Schutzfolie überspannt, die außerhalb der Zelle an die Dachhaut angefügt, beispielsweise mit ihr verklebt, ist. Diese Art der Befestigung gewährleistet eine lange Lebensdauer der Zelle.
Als günstig hat es sich erwiesen, wenigstens einen Strang in einen Streifen aus einer flexiblen Werkstoffbahn einzulegen und seine Endkontakte als Schnellanschlußeinrichtungen auszubilden, wobei gegebenenfalls mehrere Streifen nebeneinander zu einer Fläche aufgespannt und miteinander elektrisch verbunden sind. Die Werkstoffbahn kann beidends mit Taschen zur Aufnahme von Verbindungsstäben versehen sein, die gegebenenfalls Teil eines Spanngerüstes sind.

Im Rahmen der Erfindung liegt vor allem ein großflächig aufspannbares Solarmodul, mit den Vorteilen der Doppelnutzung: Stromerzeugung/Schattenspende, Witterungsschutz folgenden Aufbaus: eine hochreißfeste Membrane ist mit Solarzellen belegt, die in eine "Schwimmfolie" eingebettet sind und gestützt bzw. geschützt sind. Dies geschieht durch eine hinterlegte Stahlplatte in unseren Breitengraden bzw. durch eine Glasplatte in eher hagelschlagarmen Regionen.

Von besonderer Bedeutung ist die Verwendung fotovoltaischer Zellen für fliegende Einsätze, wozu erfindungsgemäß flexible Werkstoffbahnen dienen, die jeweils mit zumindest einem der beschriebenen Stränge versehen sind; diese Werkstoffbahnen können problemlos transportiert und am Einsatzort mittels eines Gerüstes zu einer größeren Fläche zusammengesetzt und gespannt werden. Die als Schnellanschlußelemente ausgebildeten Endkontakte jedes Stranges werden mit den benachbarten Strängen verbunden, die gesamte Fläche wird dann an eine Batterie od. dgl. angeschlossen, die nun problemlos aufgeladen zu werden vermag.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
Fig. 1: die Seitenansicht einer Überdachungskonstruktion mit fotovoltaischen Zellen;
Fig. 2: die Draufsicht auf einen Teil der Fig. 1;
Fig. 3: einen Strang fotovoltaischer Zellen;
Fig. 4: die Draufsicht auf ein Anwendungsbeispiel;
Fig. 5: den Schnitt durch Fig. 4 nach deren Linie V - V;
Fig. 6: die Draufsicht auf einen Teil einer Dachhaut;
Fig. 7: den Schnitt durch Fig. 6 nach deren Linie VII - VII;
Fig. 8: einen Dachhautstreifen in Draufsicht;
Fig. 9: einen Teil der Fig. 8 in Seitenansicht;
Fig. 10 und Fig. 11: Seitenansichten von Anwendungsbeispielen.

Eine Überdachungskonstruktion 10 besteht aus mehreren gleichförmigen Gestellen 12 mit an diesen aufgespannten Dachhäuten 14.

Bei jedem der Gestelle 12 tragen jeweils vier -- an den Ecken eines Quadrates aufragende - Stützen 16 einer beispielsweisen Höhe h von 10 m ein Dachgestänge aus Stäben 18,19, die sich -- in der Art eines liegenden "X" -- an einem mittigen Knotenpunkt 20 kreuzen und endwärts in einem Abstand i voneinander bei oberen Spannpunkten 21 und unteren Spannpunkten 22 an den Stützen 16 befestigt sind. Jeweils benachbarte Knotenpunkte 20 des Dachgestänges sind durch horizontale Bolzenstäbe 24 verbunden, die eine diagonal verlaufende Versteifung bilden.

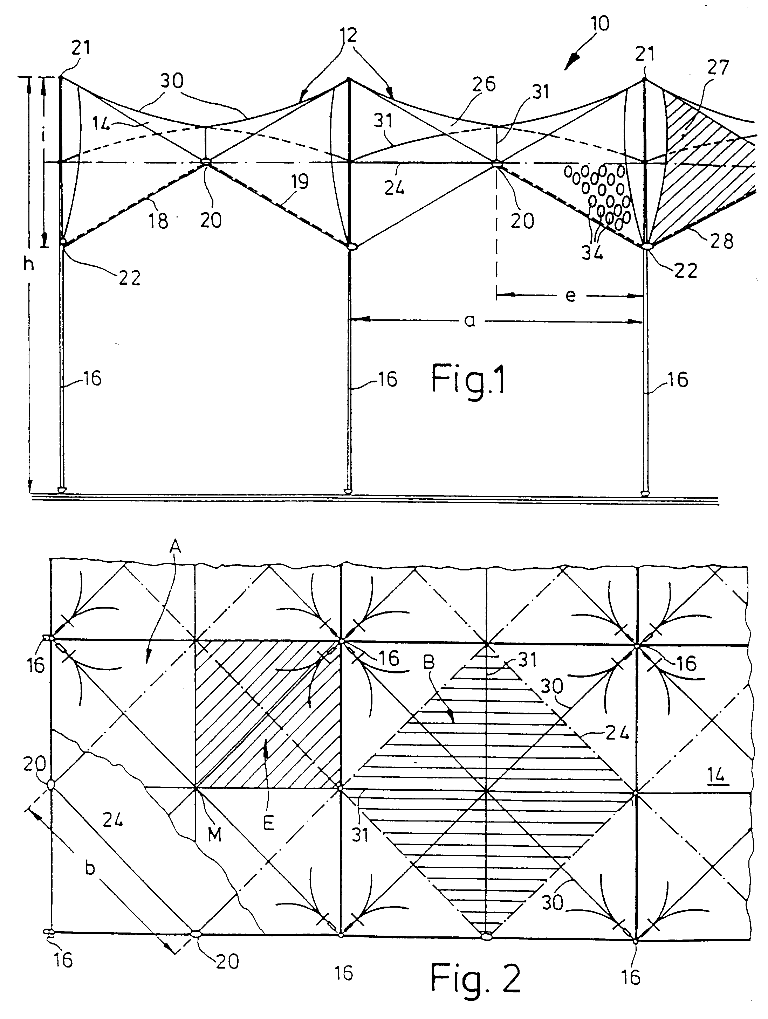

Diese Überdachungskonstruktion 10 enthält gemäß Fig. 2 quadratische Grundrißflächen A,B,C; das größte Quadrat A wird durch die Stützen 16 und deren Horizontalabstand a, das mittlere Quadrat B durch jene horizontalen Bolzenstäbe 24 und deren Länge b bestimmt, welch letztere die Diagonale des kleinsten Quadrates E einer dem halben Stützenabstand a bzw. dem Abstand des Knotenpunktes 20 von den Streben 16 entsprechenden Seitenlänge e darstellt.

Zwischen den vier Stützen 16 ist die Dachhaut 14 aus einer geschlossenen Mittelfläche 26 und bugartigen Zipfelstücken 27 aufgespannt; eines dieser Zipfelstücke 27 ist in Fig. 1 rechts besonders angedeutet. Die untere Ecke dieses Zipfelstückes 27 ist an den unteren Spannpunkt 22 angeschlossen, die von diesem ausgehende Seitenkante 28 an die Stäbe 18,19. Die Dachhaut 14 ist zwischen den unteren Spannpunkten 22, den oberen Spannpunkten 21 sowie den Stäben 18,19 so aufgehängt, daß zwei diagonale Kammlinien 30 und zwei diese im Dachteilmittelpunkt M kreuzende Zuglinien 31 entstehen.

Auf der flattersicher verspannten Dachhaut 14 sind in Fig. 1 bei 34 fotovoltaische Zellen angedeutet, welche das Sonnenlicht direkt in elektrische Energie umwandeln.

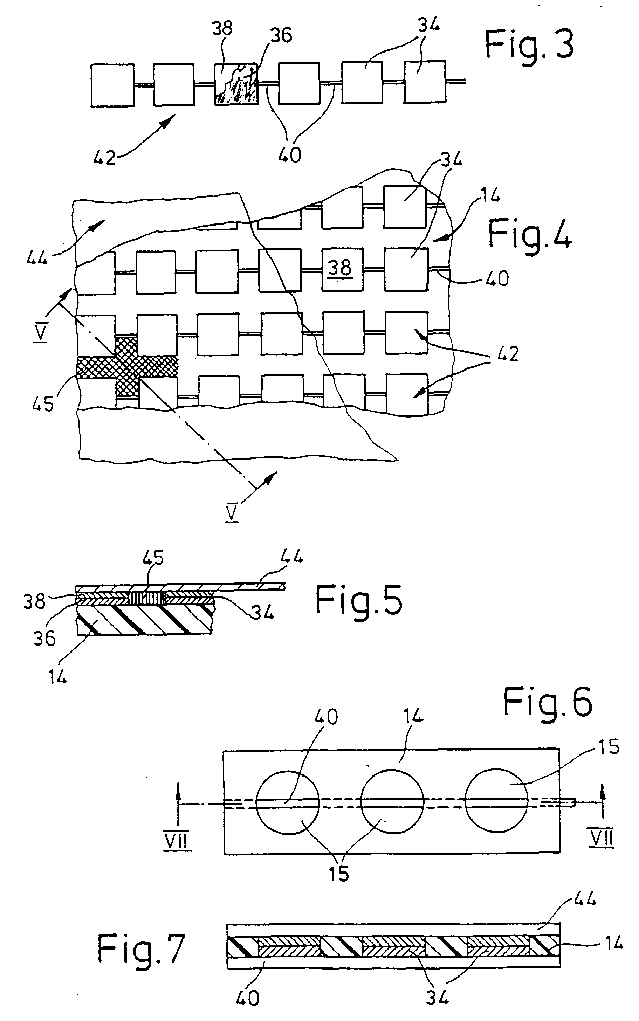

Wie Fig. 3 erkennen läßt, bestehen die fotovolatischen Zellen 34 aus dünnen Sockelplättchen 36 aus Leichtmetall, die jeweils einseitig von einer fotovoltaisch aktiven Schicht 38 überzogen sind. Eine Mehrzahl dieser Zellen 34 wird durch elektrische Verbindungen 40 zu einem Strang 42 zusammengefügt, vorbei zwischen den Zellen 34 Abstände verbleiben.

Der Strang 42 wird auf ein Gewebe 14 aufgelegt und darüber gemäß Fig. 4,5 eine transluzente Schutzfolie 44 gelegt. Letztere wird in den genannten Zwischenräumen (und nur dort) mit dem Gewebe 14 bei 45 verschweißt oder verklebt.

Nach Fig. 6,7 werden die Zellen 34 in Aussparungen 15 des Gewebes 14 eingelegt und mit diesem nur am Folienrand verklebt. Die elektrische Verbindung erfolgt im Nachhinein.

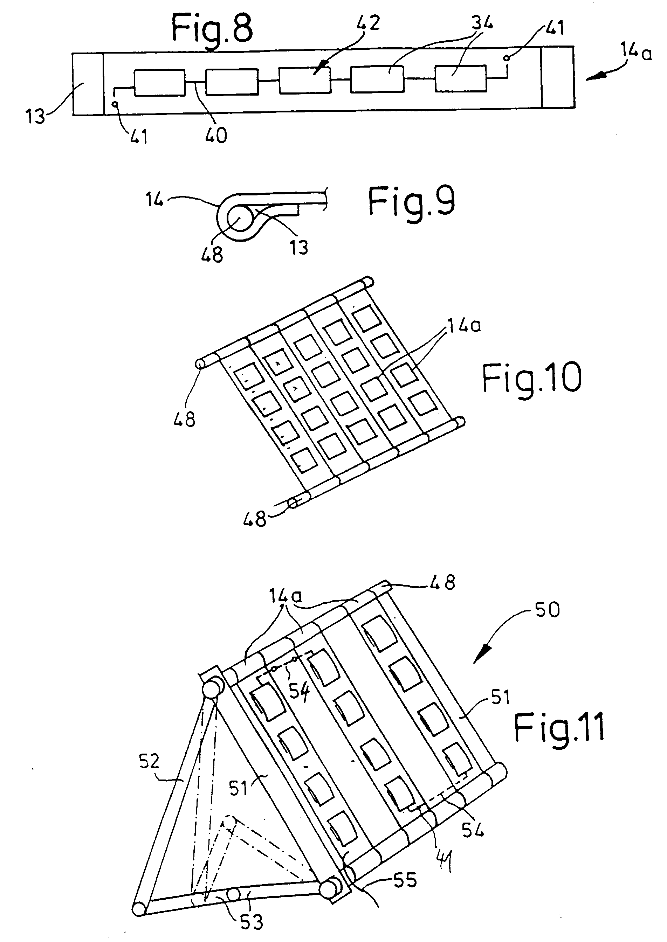

Auf einem Gewebestreifen 14ₐ werden nach Fig. 8,9 mehrere zu einem Strang zusammengefaßte Solarzellen 34 befestigt, deren elektrische Verbindung 40 Endkontakte 41 aufweist. Dieser Gewebestreifen 14ₐ ist an zwei Kanten mit Aufnahmetaschen 13 für Tragrohre 48 versehen.

Mehrere dieser Dachhautstreifen 14ₐ können durch derartige Tragrohre 48 miteinander verbunden und gemäß Fig. 10 zu einer Fläche aufgespannt werden, beispielsweise als Teil eines Spanngestells 50, wie es in Fig. 11 angedeutet ist; an zwei das Tragrohrpaar 48 in Spannabstand haltenden Spreizprofilen 51 greifen Stützstäbe 52 und klappbare Gelenkarme 53 an.

Die druckknopfartigen Endkontakte 41 werden durch Leitungslaschen 54 miteinander und endwärts durch Kabel 55 mit einem aus Gründen der Übersichtlichkeit nicht dargestellten Ladegerät verbunden.

Diese Ausführung kann als eine Art Solarset zum Aufladen von Batterien platzsparend auf Reisen mitgeführt werden.

## Patentansprüche

1. Vorrichtung mit einer flexiblen Fläche (14,14a) zur Aufnahme fotovoltaischer Zellen (34) bei der die fotovoltaischen Zellen (34) an einen Stromabnehmer anschließbar ausgebildet sind sowie an der flexiblen Fläche (14,14a) mittels einer darüber angebrachten transluzenten Schutzfolie (44) angeordnet sind, wobei einzelne Zellen (34) durch elektrische Verbindungen (40) zu einem Strang (42) zusammengefügt sind und zwischen den einzelnen Zellen (34) Abstände verbleiben,
dadurch gekennzeichnet,
daß die flexible Fläche (14,14a) eine hochreißfeste Membrane ist, und die auf sie aufgelegten Zellen (34) dadurch schwimmend eingebettet sind, daß die transluzente Schutzfolie (44) nur in den Zwischenräumen zwischen den einzelnen Zellen (34) mit der flexiblen Fläche (14,14a) durch Klebung oder Schweißung (45) verbunden ist.

2. Vorrichtung mit einer flexiblen Fläche (14,14a) zur Aufnahme fotovoltaischer Zellen (34), bei der die Zellen (34) an einen Stromabnehmer anschließbar ausgebildet sind und die fotovoltaischen Zellen (34) an der flexiblen Fläche (14,14a) mittels einer darüber angebrachten transluzenten Schutzfolie (44) angeordnet sind, dadurch gekennzeichnet, daß die flexible Fläche (14,14a) eine hochreißfeste Membrane ist und die Zellen (34) dadurch schwimmend eingebettet sind, daß sie in Aussparungen (15) der flexiblen Fläche (14) eingelegt sind und eine Verklebung nur am Folienrand der transluzenten Schutzfolie besteht.

3. Vorrichtung nach Anspruch 1 oder 2, dadurch gekennzeichnet, daß die transluzente Schutzfolie (44) mit einer Glasplatte oder einer hinterlegten Metallplatte als Schutzelement verbunden ist.

4. Vorrichtung nach einem der Ansprüche 1 bis 3, dadurch gekennzeichnet, daß die Zelle (34) eine Schicht (38) aus Silizium oder aus Kadmiumderivaten auf einer Trägerplatte (36) enthält.

5. Vorrichtung nach wenigstens einem der Ansprüche 1 bis 4, dadurch gekennzeichnet, daß wenigstens ein Strang (42) in einen Streifen (14a) aus einer flexiblen Werkstoffbahn eingelegt ist und seine Endkontakte (41) als Schnellanschlußeinrichtungen ausgebildet sind, wobei gegebenenfalls mehrere Streifen (14a) nebeneinander zu einer Fläche aufgespannt und miteinander elektrisch verbunden sind.

6. Vorrichtung nach Anspruch 5, dadurch gekennzeichnet, daß die Werkstoffbahn (14a) beidends mit Taschen (13) zur Aufnahme von Verbindungsstäben (48) od. dgl. versehen ist.

7. Vorrichtung nach Anspruch 5 oder 6, dadurch gekennzeichnet, daß die Verbindungsstäbe (48) Teil eines Spanngerüstes (50) sind.

8. Vorrichtung nach wenigstens einem der Ansprüche 1 bis 7, dadurch gekennzeichnet, daß die flexible Fläche (14,14a) eine auf Gestellteilen (12,16;50,51) aufgespannte Dachhaut zum Beschatten von Flächen ist.

## Claims

1. A device with a flexible surface (14, 14a) for receiving photovoltaic cells (34) in which the photovoltaic cells (34) are adapted for connection to a current collector and are disposed on the flexible surface (14, 14a) by means of a translucent protective film (44) provided over them, individual cells (34) being connected by electrical connections (40) to form a string (42), gaps being left between the individual cells (34), characterised in that the flexible surface (14, 14a) is a highly tear-resistant membrane, and the cells (34) placed on it are embedded in a floating fashion in that the translucent protective film (44) is connected to the flexible surface (14, 14a) by adhesion or welding (45) only in the intermediate spaces between the individual cells (34).

2. A device with a flexible surface (14, 14a) for receiving photovoltaic cells (34) in which the cells (34) are adapted for connection to a current collector, the photovoltaic cells (34) being disposed on the flexible surface (14, 14a) by means of a translucent protective film (44) provided over them, characterised in that the flexible surface (14, 14a) is a highly tear-resistant membrane and the cells (34) are embedded in floating manner in that they are laid in recesses (15) in the flexible surface (14), gluing being performed only at the edge of the translucent protective film.

3. A device according to Claim 1 or 2, characterised in that the translucent protective film (44) is connected to a glass plate or a metal plate placed behind and serving as a protective element.

4. A device according to one of Claims 1 to 3, characterised in that the cell (34) comprises a coating (38) of silicon or cadmium derivatives on a carrier plate (36).

5. A device according to at least one of Claims 1 to 4, characterised in that at least one string (42) is laid in a strip (14a) of a flexible web of material, its end contacts (41) being constructed as rapid connection means whereby if necessary a plurality of strips (14a) are stretched out beside one another to form a flat structure and are electrically connected to one another.

6. A device according to Claim 5, characterised in that the web of material (14a) is provided at both ends with pockets (13) to receive connecting rods (48) or the like.

7. A device according to Claim 5 or 6, characterised in that the connecting rods (48) are part of a tensioning frame (50).

8. A device according to at least one of Claims 1 to 7, characterised in that the flexible surface (14, 14a) is a roof skin stretched over frame parts (12, 16; 50, 51) to provide shaded areas.

## Revendications

1. Dispositif avec une surface flexible (14, 14a) pour recevoir des cellules photovoltaïques (34), dans lequel les cellules photovoltaïques (34) sont constituées de façon à pouvoir être raccordées à une prise de courant et sont disposées sur la surface flexible (14, 14a) au moyen d'une feuille de protection (44) translucide fixée dessus, différentes cellules (34) étant réunies par des liaisons électriques (40) en un cordon (42) et des intervalles subsistant entre les différentes cellules (34),
caractérisé en ce que
la surface flexible (14, 14a) est une membrane très résistante aux déchirures et les cellules (34) fixées dessus sont noyées dedans de façon flottante afin que la feuille de protection translucide (44) ne soit reliée que dans les intervalles entre les différentes cellules (34) à la surface flexible (14, 14a) par collage ou par soudage (45).

2. Dispositif avec une surface flexible (14, 14a) pour recevoir des cellules photovoltaïques (34), dans lequel les cellules photovoltaïques (34) sont constituées de façon à pouvoir être raccordées à une prise de courant et les cellules photovoltaïques (34) sont disposées sur la surface flexible (14, 14a) au moyen d'une feuille de protection (44) translucide fixée dessus,
caractérisé en ce que
la surface flexible (14, 14a) est une membrane très résistante aux déchirures et les cellules (34) sont noyées dedans de façon flottante, afin d'être insérées dans des évidements (15) de la surface flexible (14) et de n'avoir un collage que sur le bord de la feuille de protection translucide.

3. Dispositif selon la revendication 1 ou 2,
caractérisé en ce que
la feuille de protection translucide (44) est reliée à une plaque de verre ou à une plaque de métal fixée par derrière, en tant qu'élément de protection.

4. Dispositif selon l'une des revendications 1 à 3,
caractérisé en ce que
la cellule (34) contient une couche (38) en silicium ou en un dérivé du cadmium sur une plaque de support ( 36)

5. Dispositif selon au moins l'une des revendications 1 à 4,
caractérisé en ce que
l'on insère au moins un cordon (42) dans une bande (14a) constituant une piste en une matière flexible et en ce que
ses contacts terminaux (41) sont constitués sous la forme de dispositifs de raccordement rapide,
le cas échéant plusieurs bandes (14a) étant tendues côte à côte pour former une surface et étant reliées électriquement les unes aux autres.

6. Dispositif selon la revendication 5,
caractérisé en ce que
la piste de matière (14a) est pourvue aux deux extrémités de poches (13) pour recevoir des barreaux (48) de liaison ou analogues.

7. Dispositif selon la revendication 5 ou 6,
caractérisé en ce que
les barreaux de liaison (48) font partie d'un châssis de tension (50).

8. Dispositif selon au moins l'une des revendications 1 à 7,
caractérisé en ce que
la surface flexible (14, 14a) est une couverture de toit, tendue sur des éléments de châssis (12, 16; 50, 51) pour mettre des surfaces à l'ombre.
